# EUROPEAN PATENT APPLICATION

(11) **EP 1 796 160 A1**
(43) Date of publication of application: **13.06.2007**
(21) Application number: 05758327.0
(22) Date of filing: 07.07.2005
(51) Int. Cl.: H01L 21/82, H01L 21/822, H01L 23/12, H01L 27/04

(54) **SEMICONDUCTOR DEVICE, POWER SUPPLY APPARATUS USING THE SAME, AND ELECTRONIC DEVICE**

(30) Priority: 20.08.2004 JP 2004240382
(71) Applicant: ROHM CO., LTD., Kyoto-shi, Kyoto 615-8585 (JP)
(72) Inventor: ISHINO, Tsutomu; c/o Rohm Co., Ltd., 21,, 6158585 (JP)
(74) Representative: McLeish, Nicholas Alistair Maxwell
(86) International application number: PCT/JP2005/012550
(87) International publication number: WO 2006/018939

(57) **Abstract**

A semiconductor device capable of suppressing diffusion of noise signals is provided. The semiconductor device 100 has a BGA (Ball GridArray) structure inwhichaplurality of electrode terminals to do input and/or output of signals from and to the outside is arranged in a matrix form. The semiconductor device 100 includes a noise source electrode terminal 10 to do input and/or output of signals, and low-impedance electrode terminals 12 and 14. The noise source electrode terminal 10 does input and/or output of signals acting as a source of noises. The low-impedance electrode terminal 12 are arranged so as to be adjacent to the noise source electrode terminal 10 in a vertical or horizontal direction. The low-impedance electrode terminal 14 is arranged so as to be adjacent to the noise source electrode terminal 10 in a slanting direction. In order to make the low-impedance electrode terminals 12 and 14 be of a low impedance, these terminals 12 and 14 are connected to a grounding potential and connected through a capacitor having a large capacitance to the grounding potential. If necessary, the low-impedance electrode terminals 12' and 14' are arranged in a place surrounding the electrode terminal that is susceptible to noises .

## Description

### TECHNICAL FIELD

The present invention relates to a semiconductor device and, more particularly, to an arrangement of electrode terminals of the semiconductor device.

### BACKGROUND TECHNOLOGY

As miniaturization of information terminals such as a portable phone, PDA (Personal Digital Assistant), or a like is progressing in recent years, the need for miniaturization of semiconductor circuits mounted therein is also increasing. In such a situation, mounting technology called BGA (Ball Grid Array) structure packaging is receiving attention. The BGA structure packaging refers to a way of packaging inwhich a package is not connected through lead terminals using lead frames to a board as employed in the case of conventional packaging such as QFP (Quad Flat Package) structure packaging, but is connected through terminals called bumps mounted on the bottom side of semiconductor circuits to the board. By employing the BGA structure packaging method, it is made possible to mount terminals in an entire portion of the bottom of semiconductor circuits, thereby eliminating the need of mounting the lead frames extending outside the semiconductor circuit, which enables a mounting area to be greatly reduced.

Developments are being made in packaging technology called CSP (Chip Size Package) packaging technology which uses the BGA structure described above in which an area of a semiconductor chip is made approximately equal to a mounting area. Moreover, packaging technology called WL (Wafer level) -CSP packaging technology in which a bump is mounted directly on a semiconductor chip is also under development, which also serves to promote the miniaturization of a semiconductor device.

Application of CSP packaging technology to a semiconductor device allows reduction in the mounting area but results in a shorter distance between terminals. Particularly, in the case of the WL-CSP packaging technology, signals are routed from a position of an electrode on a surface of a semiconductor chip to that of a bump by being re-wired and part of the electrode called a post is connected to the bump and, therefore, the existence of parasitic capacitance among electrodes becomes not negligible, thus presenting problems of the occurrence of crosstalk among electrode terminals and/or of diffusion of noises. A technology is disclosed in, for example, Patent Reference 1 in which crosstalk would be reduced by using, as a grounding potential, a terminal being adjacent to a terminal for signals in which crosstalk may occur.

Japanese Patent Application Laid-open No. 2000-349192

### DISCLOSURE OF THE INVENTION

### PROBLEMS TO BE SOLVED BY THE INVENTION

According to the conventional technology disclosed in the above Patent Reference 1, crosstalk can be suppressed if the sufficiently adequate number of electrode terminals to be used as grounding terminals can be provided, however, there are some cases inwhich it is impossible toprovide the grounding terminals enough to surround peripheral portions of signals in which crosstalk may occur. Moreover, when a package is made smaller and a distance among terminals becomes shorter, in some cases, stable operations of a semiconductor circuit cannot be achieved satisfactorily only by surrounding a terminal acting as a source of noises with grounding terminals. For example, in a switching power supply apparatus, its controlling circuit, or a like, in the case of application of the CSP packaging technology that employs the BGA structure packaging described above, if unwanted noise signals diffuse around in a circuit used to internally generate a reference voltage, there is a fear of the degradation of characteristics of the circuit itself.

The present invention is made in view of these problems, and a general purpose thereof is to provide a semiconductor device which is capable of easily and reliably reducing the diffusion of unwanted signals.

### MEANS FOR SOLVING THE PROBLEMS

An embodiment of the present invention relates to a semiconductor device. In the semiconductor device having a plurality of electrode terminals to do input and/or output of signals, low-impedance electrode terminals are mounted in a place surrounding an electrode terminal used to do input and/or output of a signal acting as a source of noises. The term "signal acting as a source of noises" refers to a signal, besides the signal containing unwanted noise components, that does not contain noises but its existence itself causes a noise to other signals. Moreover, the term "place" in the phrase of "place surrounding an electrode terminal" refers to an area in which electrode terminals being adjacent to one another in a vertical or horizontal direction are mounted if the electrode terminals are arranged in a matrix form and to an area in which electrode terminals being adjacent to one another in a slanting direction are mounted in some cases.

According to the embodiment of the present invention, noise components are removed by low-impedance electrode terminals and, as a result, diffusion of unwanted signals to the outside of low-impedance electrode terminals can be reduced.

An electrode terminal to do input and/or output of a signal that poorly withstands noises and an electrode terminal to do input and/or output of a signal acting as a source of noises may be isolated from each other by the low-impedance electrode terminals. The "signal susceptible to noises" refers to a signal that causes a failure in operating a semiconductor device or to a signal that causes the degradation of characteristics of the semiconductor device when noises are mixed into signals. Since the noise components of signals acting as a source of noises are decreased by low-impedance electrode terminals, the mixing of noises into signals susceptible to noises can be suppressed.

Low-impedance electrode terminals may be arranged in places surrounding electrode terminals to do input and/or output of signals susceptible to noises. By isolating signals acting as a source of noises from signals susceptible to noises by using signals having a low impedance, crosstalk between two signals and/or mixing noises into signals can be preferably reduced.

The interval between the electrode terminal to do input and/or output of signals acting as a source of noises and the electrode terminals to do input and/or output of signals susceptible to noises may be two times or more longer than a unit interval between electrode terminals being adjacent to one another. The term "unit interval between electrode terminals being adjacent to one another" refers to a distance between end faces of electrode terminals made of a solder bump or a like. By making the interval between the above two electrode terminals for signals be two times more longer the unit interval, crosstalk or mixing of noises can be reduced preferably.

At least one of the low-impedance electrode terminals may be set at a low impedance by using a capacitor mounted on the board to which a semiconductor device is connected. By connecting the electrode terminals to a grounding potential by using a capacitor with large capacitance such as a by-pass capacitor, an impedance of the electrode terminals can be made lower.

The semiconductor device includes a circuit to generate a switching signal and a signal acting as a source of a noise may be a switching signal. The term "switching signal" refers to a signal inwhich, for example, a high or low occurs repeatedly, which includes a clock signal, PWM (Pulse Width Modulation) signal, sawtooth-wave signal, or a like. In the circuit to generate such a switching signal, by surrounding a place around an electrode terminal from which the switching signal is output with low-impedance electrode terminals, diffusion of the switching signal being a noise signal toward the outside of the low-impedance electrode terminal can be reduced.

The semiconductor device may include a circuit to generate a switching signal and a signal acting as a source of noises is the switching signal and a signal susceptible to noises may be a signal needed to generate a reference voltage to be used in a semiconductor device. In the semiconductor device, there is a case where, by taking diffusion of a signal in consideration, a power supply voltage is provided individually to each of a circuit block to generate a reference voltage and a block to generate a switching signal. In such a semiconductor device, by cutting the electrode terminal for signals needed to generate a reference voltage electrically off by using an electrode terminal for switching signals and a low-impedance electrode terminal, operations of circuits can be stabilized and noises can be reduced.

The semiconductor device may have a control circuit of a switching regulator and a signal acting as a source of noises may be a switching signal to be output from a switching transistor of the switching regulator. The term "switching regulator" here refers to a circuit to boost or lower an input voltage by turning on or off the switching transistor being connected in series or in parallel to an input voltage source to control a current to be applied to an inductor or capacitor so that energy conversion is made. In many cases, the inductor and capacitor to make the energy conversion and to smooth an output voltage are attached as external components and there are circuits in which up to switching transistors are integrated into the semiconductor device. In the control circuit of the switching regulator, by arranging a terminal to feed back an output voltage, a terminal to ground a synchronous rectifying transistor or a rectifying diode, an input terminal to apply an input voltage to a main transistor, or a like, in places surrounding a switching signal output from the switching transistor, noises output from the switching transistor can be preferably removed.

Moreover, the semiconductor device may be also a control circuit to generate a switching signal to turn on/off the switching transistor of the switching regulator and a signal acting as a source of noises may be a control signal to turn on/off the switching element. In some cases, the switching transistor serving as the switching element in the switching regulator is placed outside the semiconductor device and, in this case, low-impedance electrode terminals may be mounted in places surrounding the electrode terminal from which a control signal to turn on/off the switching transistor.

The semiconductor device may be of the CSP structure. When a semiconductor device is of the CSP structure or of the WL-CSP in which a distance among electrode terminals is shorter, by applying the above-described method of arranging the electrode terminals, preferably, diffusion of signals is reduced.

It is to be noted that any arbitrary combination of the aforementioned constituent elements and the expression of the present invention changed among a method, an apparatus, a system and so forth are also effective as the embodiments of the present invention.

### EFFECTS OF THE INVENTION

According to the semiconductor device of the present invention, it is made possible to reduce diffusion of signals toward places surrounding a signal acting as a source of noises and to suppress mixing of noises from the places surrounding the noise signal.

### BRIEF DESCRIPTION OF THE DRAWINGS

Fig. 1 is a plan view of a semiconductor device, when seen from an electrode terminal side, of an embodiment of the present invention;
Fig. 2 is a cross-sectional view of the semiconductor device of Fig. 1 taken along the line 2-2;
Fig. 3 is a circuit diagram showing an equivalent model of an electrode terminal;
Fig. 4 is a circuit diagram showing configurations of a power supply apparatus;
Fig. 5 is a diagram showing an arrangement of electrode terminals of the semiconductor device used in the power supply apparatus; and
Fig. 6 is a block diagram showing configurations of the electrode terminal in which the power supply apparatus of Fig. 4 is installed.

### DESCRIPTION OF REFERENCE NUMERALS

C1 capacitor, SW1 main switch, SW2 synchronous rectifying switch, 10 noise source electrode terminal, 12 low impedance electrode terminal, 14 low impedance electrode terminal, 16 noise source, 18 electrode terminal for signals susceptible to_noise, 20 silicon wafer, 22 passivation, 24 pad, 26 insulating resin layer, 28 re-wiring line, 30 post, 32 solder bump, 34 sealing resin, 40 switching regulator control circuit, 42 error amplifier, 44 voltage comparator, 46 driver circuit, 48 sawtooth wave oscillator, 50 linear regulator, 60 inverter, 70 reference voltage source, 80 battery, 82 by-pass capacitor, 84 by-pass capacitor, 90 control unit, 100 semiconductor device, 200 power supply apparatus.

### BEST MODE FOR CARRYING OUT THE INVENTION

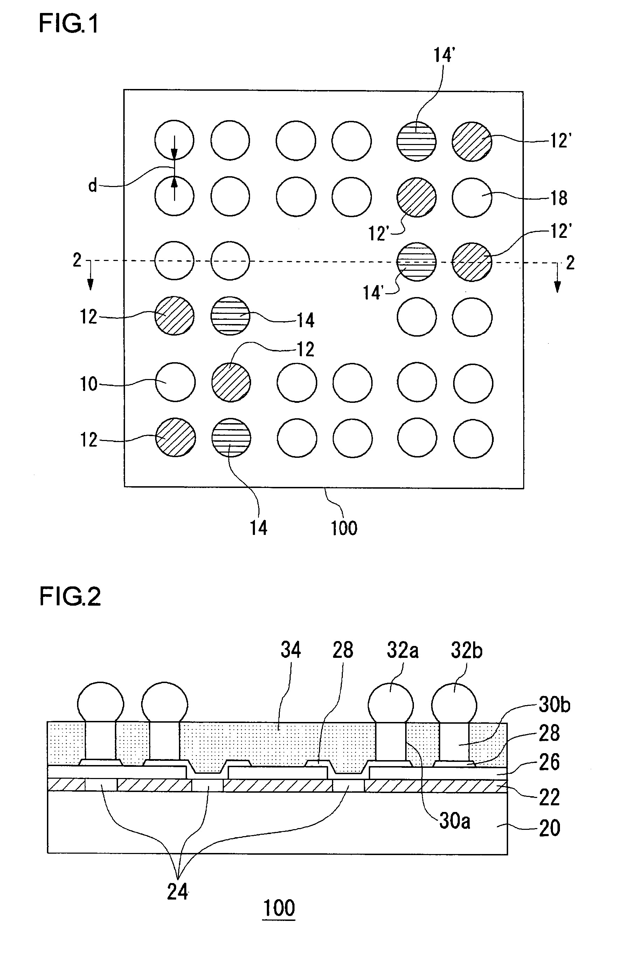

Fig. 1 is a plan view of the semiconductor device 100, when seen from an electrode terminal side, of an embodiment of the present invention. The semiconductor device 100 has a BGA structure and a plurality of electrode terminals, which are arranged in a matrix form, to do input and/or output of signals from and to the outside. The noise source electrode terminal 10 is an electrode terminal to do input and/or output of signals-acting as a source of noises. Each of the low impedance electrode terminals 12 is adjacent to the noise source electrode terminal 10 in a vertical or horizontal direction and serves as the electrode terminal having a low impedance. The low impedance electrode terminals 14 are also adjacent to the noise source electrode terminal 10 in a slanting direction and serve as the electrode terminals having a low impedance.

Fig. 2 is a cross-sectional view of the semiconductor device 100 of Fig. 1 taken along the line 2-2. The semiconductor device 100 is of the WL-CSP structure in which a connecting electrode with the outside is formed directly on a semiconductor wafer. The semiconductor device 100 includes a silicon wafer 20, a passivation 22, pads 24, an insulating resin layer 26, re-wiring lines 28, posts 30, solder bumps 32, and a sealing resin 34. On the silicon wafer 20 are formed a semiconductor integrated circuit containing elements such as a transistor and a pads to be used for input and/or output of signals are formed. The pads are ordinarily made of a material such as aluminum.

The passivation 22 is a silicon nitride film or a like and an apertures is made in an upper portion of the pad. The re-wiring lines 28 are used to route signals from a position of each of the pads 24 to a position of each of the solder bumps 32 which is a final position for formation of electrode terminals and to connect signals to each of the posts 30. Each of the posts 30 is made of copper and connects the solder bumps 32 electrically to the re-wiring lines 28.

In the case of the WL-CSP structure, since a distance between the posts 30a and 30b both being adjacent to each other is short, parasitic capacitance exists between the posts 30a and30b. In order to estimate the parasitic capacitance, a simple model is here given. That is, it is assumed that each of the posts 30a and 30b is a rectangular solid having a height "h", width "x" and depth "x" and a distance between surfaces of the two posts 30a and 30b facing each other is "d". An area S of the surface where the post 30a faces the post 30b is shown by an equation S = x × h and the parasitic capacitance C between the posts 30a and 30b is shown by an equation C = ε × S/d. Where, ε is permittivity of the sealing resin 34. The parasitic capacitance increases as a distance between electrode terminals becomes shorter. In the semiconductor device 100 having the WL-CSP structure shown in Fig. 1, such parasitic capacitance exists among electrode terminals. The parasitic capacitance exists not only between the posts 30a and 30b but also between the re-wiring lines 28 connected among electrode terminals.

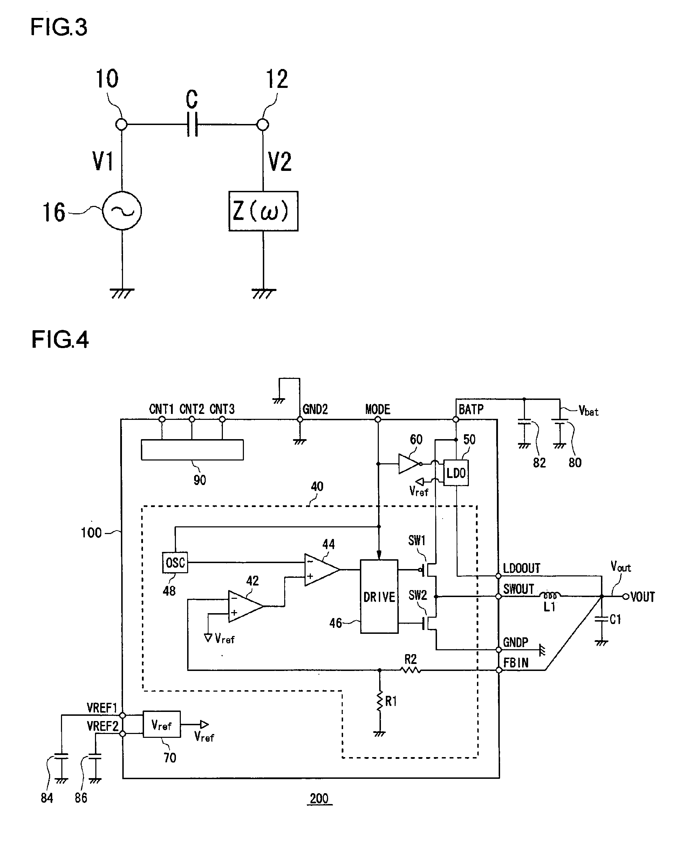

Fig. 3 is a circuit diagram showing an equivalent model of an electrode terminal. It is now assumed that, between the noise source electrode terminal 10 and the low impedance electrode terminal, there exists parasitic capacitance C between posts as described above and complex impedance of the low impedance electrode terminal 12 is given as Z (ω) being a function of a frequency ω. The noise source 16 is connected to the noise source electrode terminal 10 to do input and/or output of signals acting as a source of noises and it is also assumed that a voltage occurring at the noise source electrode terminal 10 is V1 and the frequency of a noise from the noise source 16 is ω. When V2 denotes a voltage that occurs at the low impedance electrode terminal, a relationship equation V2 = Z (ω)/(1/jωC + Z (ω)) × V1 holds. Therefore, the smaller the value of the impedance Z (ω) of the low impedance electrode terminal 12 is made, that is, the lower the impedance is made, the smaller the voltage V2 occurring at each of the low impedance electrode terminals 12 becomes. As a result, signals that diffuse toward each of the low impedance electrode terminals 12 from the noise source 16 are reduced more.

Referring to Fig. 1 again, in the semiconductor device 100 of the embodiment, the low impedance electrode terminals 12 being adjacent to the noise source electrode terminal 10 in a vertical or horizontal direction are considered to have a low impedance. The impedance of the electrode terminal refers to an impedance occurring in the electrode terminal when a package, after its semiconductor device 100 has been mounted on a printed-circuit board and its circuit components connected on the periphery of the semiconductor device 100 have been mounted, gets into an operational state. Therefore, the low impedance occurs when the electrode terminal is grounded or is connected to a ground potential via a capacitor having large capacitance. In general, an electronic circuit is designed so that its input impedance is high and its output impedance is low. However, even if an input terminal of a circuit block is designed so as to be of a high impedance, when the input terminal is connected to a grounding potential via a capacitor having large capacitance such as a by-pass capacitor, a low impedance occurs in its input terminal. The term "impedance" here refers to complex impedance. Therefore, it is desirable that the alternating current impedance of the low impedance electrode terminals 12 is set to be low in a frequency band of a signal whose diffusion is required to be reduced in particular.

As described above, by setting the noise source electrode terminal 10 to do input and/or output of signals acting as a source of noises and the low impedance electrode terminals 12 being adjacent to one another in a vertical or horizontal direction so that their impedance is low, the voltage V2 occurring in each of the low impedance electrode terminals 12 shown in Fig. 3 becomes low and, as a result, diffusion of signals toward other electrode terminals can be reduced.

Moreover, the low impedance electrode terminals 14 being adjacent to the noise source electrode terminal 10 in a slanting direction are set, if necessary, so that its impedance is low. The low impedance electrode terminals 14 are adjacent to the electrode terminals to do input and/or output of signals acting as a source of noises in a slanting direction. The parasitic capacitance between electrode terminals is determined by the distance "d" between the posts and, therefore, in the semiconductor device in which electrode terminals are tightly arranged, by setting the low impedance electrode terminals 14 so that their impedance is low, the diffusion of noises can be preferably reduced more.

Next, an arrangement of electrode terminals to achieve more stable operations of the semiconductor device is described. The electrode terminal 18 shown in Fig. 1 is the electrode terminal for signals susceptible to_noises and, in places surrounding the electrode terminal 18, the low impedance electrode terminal 12' being adjacent to the electrode terminal 18 in a vertical or horizontal direction and having a low impedance are arranged. In addition, the electrode terminal 14' being adjacent to the electrode terminal for signals susceptible to noises 18 being adjacent in a slanting direction is set, if necessary, so that its impedance is low.

Thus, by providing the low impedance electrode terminals 12' and 14' in places surrounding the electrode terminal 18 that is susceptible to noises, mixing of noises from the outside can be suppressed and stable operations of the semiconductor device are made possible. Besides, an interval between the noise source electrode terminal 10 and the electrode terminal 18 which is susceptible to noises is set to be sufficiently long than the unit interval "d", shown in Fig. 1, between electrode terminals being adjacent to one another and, therefore, mixing of noises and occurrence of crosstalk can be more preferably reduced. Though the interval between the noise source electrode terminal 10 and the electrode terminal for signals 18 varies depending on the frequency of a noise, as shown in Fig. 1, when the interval is by two times or more longer than the unit interval "d", an effect of reducing the mixing of signals can be obtained.

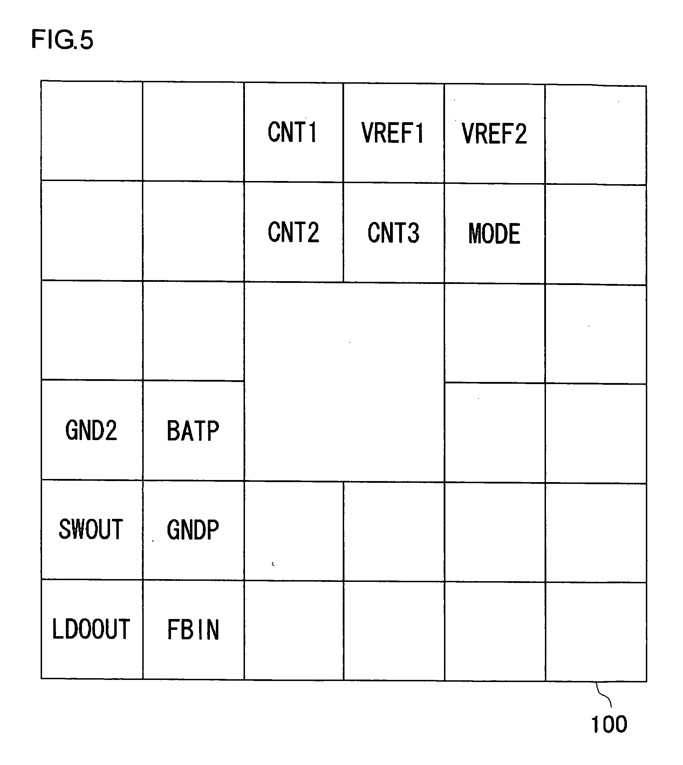

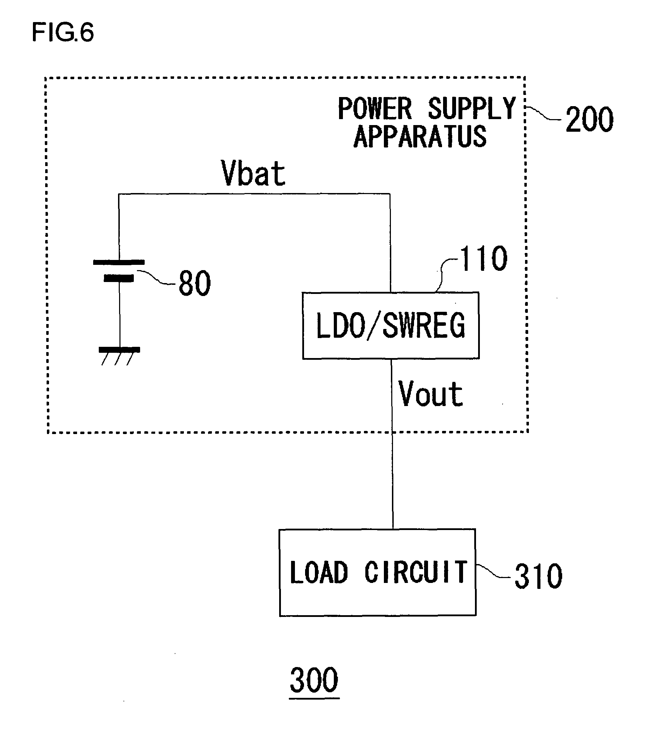

Next, the application of the present invention to a power supply apparatus is explained. The power supply apparatus is a power circuit to output a constant voltage by using two systems including a switching regulator and a linear regulator. Fig. 4 is a circuit diagram showing configurations of the power supply apparatus 200. Fig. 5 shows an arrangement of electrode terminals of the semiconductor device 100. Fig. 6 is a block diagram showing configurations of an electronic device 300 in which the power supply apparatus 200 is installed.

The electronic device 300 shown in Fig. 6 is a battery-driven small-sized information terminal device such as a portable phone, PDA, CD (Compact Disc) player, or a like and has the power supply apparatus 200 and a load circuit 310. The power supply apparatus 200 includes a battery 80 and a voltage generating circuit 110. The battery 80 is, for example, a lithium-ion battery and outputs a battery voltage Vbat of about 3V to about 4V. The voltage generating circuit 110 has a switching regulator and a linear regulator and stabilizes an input battery voltage Vbat and supplies the stabilized voltage to the load circuit 310. The load circuit 310 is one of the circuits used in the electronic device 300 to which a constant supply voltage is allowed to be applied at all times even when the battery has become exhausted and which corresponds to a digital IC (Integrated Circuit) or an analog IC that requires the supply voltage Vdd (=3V).

Configurations of the power supply apparatus 200 are described by referring to Fig. 4. The power supply apparatus 200 includes a semiconductor device 100, a by-pass capacitor 82, the battery 80, an inductor L1, a capacitor C1, and by-pass capacitor 84 and 86. The power supply apparatus 200 outputs a predetermined DC (Direct Current) voltage via an output terminal Vout. The semiconductor device 100 to be used for the power supply apparatus 200 is a functional IC obtained by integrating a switching regulator control circuit 40 , an inverter 60, a linear regulator 50, a reference voltage source 70, and a control unit 90 on a substrate of one semiconductor device. The switching regulator control circuit 40 constitutes a step-down type switching regulator together with the inductor L1 and the capacitor C1. The semiconductor device 100 includes, as a terminal for input and/or output of signals from and to the outside, a GNDD2 terminal, a MODE terminal, a BATP terminal, an LDOOUT terminal, a SWOUT terminal, a GNDP terminal, a FBIN terminal, a VREF1 terminal, a VREF2 terminal, and CNT1 terminal to CNT3 terminals.

To the BATP terminal is applied a battery voltage Vbat from the battery 80. Between the BATP terminal and the battery 80 is provided the by-pass capacitor 82. The by-pass capacitor 82 is mounted to stabilize voltages applied to the BATP terminal and to remove noises. The battery voltage Vbat input from the BATP terminal is applied to the switching regulator control circuit 40 and the linear regulator 50. Each grounding potential in the power supply apparatus 200 is connected via the GND2 to an outside grounding potential and the potential is clamped. To the MODE terminal is input a signal used to switch between the linear regulator 50 and the switching regulator control circuit 40. The signal is input to an enabling terminal of the linear regulator 50 and of the switching regulator control circuit 40. The signal inverted by the inverter 60 between a high and a low is input to each of the linear regulator 50 and switching regulator control circuit 40 and, therefore, when one of either the linear regulator 50 or the switching regulator control circuit 40 is turned on, the other of either the linear regulator 50 or the switching regulator control circuit 40 is turned off.

The switching regulator control circuit 40 includes an error amplifier 42, a voltage comparator 44, a driver circuit 46, a sawtooth-wave oscillator 48, a main switch SW1, and a synchronous rectifying switch SW2. A source terminal of the main switch SW1 is connected to the BATP terminal and its drain terminal is connected to the synchronous rectifying switch SW2. A source terminal of the synchronous rectifying switch SW2 is connected to the GNDP terminal. A voltage at a connected point between the main switch SW1 and the synchronous rectifying switch SW2 is output from the SWOUT terminal. The SWOUT terminal is connected to the outside inductor L1. The main switch SW1 and synchronous rectifying switch SW2 are alternately turned on/off and a battery voltage Vbat is lowered by energy-conversion to be made by the inductor L1 and capacitor C1. The inductor L1 and capacitor C1 make up a low-pass filter and a smoothed output voltage Vout is output to the VOUT terminal.

The VOUT terminal is connected to the FBIN terminal and an output voltage Vout is fed back. The output voltage Vout is divided by resistance of resistors R1 and R2 and is compared with a reference voltage Vref. The reference voltage source 70 generates a reference voltage Vref. The by-pass capacitors 84 and 86 are connected to the VREF1 terminal and VREF2 terminal to stabilize the reference voltage source 70. To the error amplifier 42 is input an output voltage Vout multiplied R1/ (R1+ R2) -fold and the reference voltage Vref. The error amplifier 42 adjusts the output signal so that the above two voltages become equal. The voltage comparator 44 generates a pulse width modulating signal based on a signal generated by the sawtooth-wave oscillator 48 and a signal output from the error amplifier 42. The driver circuit 46 turns on/off the main switch SW1 and synchronous rectifying switch SW2 based on the pulse width modulating signal. Thus, the output voltage Vout is stabilized so as to approach a predetermined voltage value (R1+R2) /R1 x Vref. Moreover, instead of the above sawtooth-wave oscillator, a triangle wave oscillator may be used to generate a pulse width modulating signal.

The linear regulator 50 is a three-terminal regulatorwhich lowers a battery voltage Vbat input to the BATP terminal and outputs the lowered voltage . A voltage from the linear regulator 50 is output through the LDOOUT terminal. The LDOOUT terminal is connected to the Vout terminal.

The control unit 90 is a circuit to control operations of the entire semiconductor device 100 and the power supply apparatus 200 is switched between its on-state and off-state according to a control signal to be input to the CNT1 terminal to CNT3 terminal. A signal to be input to the MODE terminal and the CNT1 to CNT3 terminal is a level signal which brings about a high or low.

The arrangement of the electrode terminals of the semiconductor device 100 having configurations described above is explained by referring to Fig. 5. In the semiconductor device 100, a signal acting as a source of noises is a switching signal output from the SWOUT terminal. Therefore, in order to suppress the diffusion of noises, low-impedance electrode terminals are arranged in a place surrounding the SWOUT terminal. Since the GNDP terminal and GND2 terminal are connected to a grounding potential, the impedance is very low. The impedance of the BATP terminal connected to the battery 80, since an internal impedance of the battery 80 is low and since the BATP terminal is grounded by the by-pass capacitor 82, is also made low. The LDOOUT terminal fromwhich a voltage of the linear regulator 50 is output is connected through the outside wirings to the capacitor C1. A capacitance of the capacitor C1 is mounted with an aim of smoothing an output voltage Vout and, therefore, its capacitance is sufficiently large. As a result, the LDOOUT terminal is also of a low impedance. Similarly, the FBIN terminal to which the output voltage Vout is fed back is connected to the capacitor C1 and, as a result, its impedance is made low.

Thus, by arranging the BATP terminal, GND2 terminal, GNDP terminal, LDOOUT terminal, and FBIN terminal all being electrode terminals having a low impedance in a place surrounding the SWOUT terminal from which a switching signal acting as a source of noises is output, diffusion of noise signals caused by a switching signal can be reduced.

The reference voltage source 70 generates a reference voltage Vref to be internally used in the semiconductor device 100 and the output voltage Vout is stabilized based on the reference voltage Vref . Therefore, the reference voltage Vref exerts a great influence on characteristics of the power supply apparatus 200 and, therefore, its high stability is required. If noises are mixed into the VREF1 and VREF2 terminals to which the by-pass capacitor for stabilization of the reference voltage source 70 is connected, the accurate generation of the reference voltage Vref is hindered. It can be said, therefore, that the VREF1 and VREF2 terminals are electrode terminals to do input and/or output of signals susceptible to noises. As shown in Fig. 5, the VREF1 terminal is isolated from the VREF2 terminal by the SWOUT terminal and the terminal having a low impedance. Each of these terminals is arranged so as to be kept farthest away from one another.

While the VREF1 and VREF2 terminals susceptible to noises, signals from the MODE terminal and from CNT1 to CNT3 terminals highly withstand noises. Each of these terminals takes either a high level value or a low level value and, therefore, mixing of noises exerts little influence on operations of circuits. Therefore, by arranging low-impedance electrode terminals in a place surrounding the SWOUT terminal and further arranging the MODE terminal and CNT1 to CNT3 terminals in a place surrounding low-impedance electrode terminals, it is made possible to keep the VREF1 and VREF2 terminals far away from the SWOUT terminal and to reduce the diffusion of signals.

The SWOUT terminal maybe arranged in anyone of four corners constituting a crest of the semiconductor device 100. In the case where a small number of electrode terminals whose impedance can be made low is available, by arranging the electrode terminal in any one of the four corners, the number of directions in which signals diffuse can be reduced to two directions.

Moreover, by arranging the VREF1 and VREF2 terminals so as to be diagonally opposite to the SWOUT terminal for signals acting as a source of noises, a distance between terminals is made longest and, therefore, diffusion of signals can be further reduced. According to the power supply apparatus 200 as shown in Figs. 4 and 5, mixing of noises into the reference voltage source 70 canbe preferably reduced and, therefore, the reference voltage Vref can be generated with high accuracy. Since the output voltage Vout from the power supply apparatus 200 is stabilized to be (R1 + R2) / R1 x Vref by being fed back and, therefore, the reference voltage Vref is generated at high accuracy, which can enhance stability of the output voltage Vout from the power supply apparatus 200.

While the embodiment of the invention has been described, such description is for illustrative purposes only and it is to be understood topersons skilled in the art that various changes and variations in combinations of each component and each process may be made without departing from the spirit of the invention.

In this embodiment, the case in which a signal acting as a source of noises is a signal generated by the semiconductor device, however, the present invention is not limited to this. For example, if a signal or a like to be input to the semiconductor device exerts an influence on other signals, a place surrounding an electrode to which a clock signal is input may be surrounded with a pad having a low impedance. The signal acting as a source of noises includes a signal of a big amplitude, a signal whose edge stands such as a clock signal and containing much high-frequency components, or a like.

The signal susceptible to noises includes, in addition to a signal required to generate a reference voltage employed in the embodiment, a signal having a voltage to be compared with a predetermined threshold voltage and being a signal having a voltage providing a little margin from the threshold voltage, an edge-triggered signal, a signal in which an amplitude component has an implication such as an amplitude modulation, or a like. By suppressing the mixing of noises into these signals, circuits can be operated in a more stable manner.

In this embodiment, effects of the semiconductor device having the WL-CSP structure are described, however, in a semiconductor device using a BGA package having a CSP structure in which silicon chips are mounted on a resin substrate and bumps are formed on the resin substrate, the same effects as achieved in the semiconductor device having the WL-CSP structure can be obtained. In addition, as a material for a post and solder bump, materials other than described in the embodiment such as gold may be employed.

In this embodiment, the semiconductor device in which the step-down type switching regulator and linear regulator are mounted in a mixed manner, however, the semiconductor device may have singly the step-down switching regulator. In this case, also, at least the BATP terminal, GNDP terminal, FBIN terminal and other grounding terminals may be arranged in a place surrounding the SWOUT terminal. In stead of the step-down type switching regulator, a step-up type switching regulator may be used. Additionally, other circuits such as a clock signal generator can be applied thereto.

### INDUSTRIAL USABILITY

The present invention can be applied to a semiconductor device formed on a semiconductor substrate.

## Claims

1. A semiconductor device comprising:
a plurality of electrode terminals to do input and/or output of signals, wherein electrode terminals each having a low impedance are arranged in a place surrounding an electrode terminal to do input and/or output of a signal acting as a source of noises.

2. The semiconductor device according to claim 1, wherein an electrode terminal to do input and/or output of a signal susceptible to noises and said electrode terminal to do input and/or output of a signal acting as a source of noises are isolated from each other by said electrode terminals each having a low impedance.

3. The semiconductor device according to claim 1, wherein electrode terminals each having a low impedance are arranged in a place surrounding said electrode terminal to do input and/or output of a signal susceptible to noises.

4. The semiconductor device according to any one of claims 1 through 3, wherein an interval between said electrode terminal to do input and/or output of a signal acting as a source of noises and said electrode terminal to do input and/or output of a signal susceptible to noises is two times or more larger than a unit interval between electrode terminals being adjacent to each other.

5. The semiconductor device according to any one of claims 1 through 3, wherein at least one of said electrode terminals each having a low impedance is set at a low impedance by a capacitor mounted on a board connected to said semiconductor device.

6. The semiconductor device according to claim 1, wherein said semiconductor device comprises a circuit to generate a switching signal and said signal acting as a source of noises is said switching signal.

7. The semiconductor device according to claim 2, wherein said semiconductor device comprises a circuit to generate a switching signal and said signal acting as a source of noises is said switching signal and said signal susceptible to noises is a signal required to generate a reference voltage in said semiconductor device.

8. The semiconductor device according to claim 1, wherein said semiconductor device is a control circuit of a switching regulator and a signal acting as a source of noises is a switching signal to be output from a switching transistor of said switching regulator.

9. The semiconductor device according to any one of claims 1 through 8, wherein said semiconductor device has a chip size package structure.

10. An electronic device comprising:
a battery; and
the semiconductor device according to claim 8 which includes a switching regulator to boost or lower a voltage and to apply the boosted or lowered voltage to a predetermined load.
